Europäisches Patentamt

(19) European Patent Office

Office européen des brevets

(11) Publication number: **0 186 769**
**B1**

## EUROPEAN PATENT SPECIFICATION

(45) Date of publication of the patent specification:
04.04.90

(51) Int. Cl.⁴: **H01L 27/04**

(21) Application number: 85114667.0

(22) Date of filing: 19.11.85

(54) Integrated circuit chip structure with wiringnet capacitive load compensation.

(30) Priority: 03.12.84 US 677618

(43) Date of publication of application:
09.07.86 Bulletin 86/28

(45) Publication of the grant of the patent:
04.04.90 Bulletin 90/14

(84) Designated Contracting States:
DE FR GB IT

(56) References cited:
GB-A- 2 011 706

PATENT ABSTRACTS OF JAPAN, vol. 6,
no. 264 (E-150)[1142], 23rd December 1982; & JP - A
- 57 160 143 (FUJITSU K.K.) 02-10-1982

(73) Proprietor: International Business Machines
Corporation, Old Orchard Road, Armonk, N.Y. 10504(US)

(72) Inventor: Culican, Edward Francis, RR1,
Box 232 Marshall Road, Hyde Park, N.Y. 12538(US)
Inventor: Pritzlaff, Philip Edward, Jr., 20F Alpine Drive,
Wappingers Falls, N.Y. 12590(US)

(74) Representative: Möhlen, Wolfgang C., Dipl.-Ing., IBM
Corporation Säumerstrasse 4, CH-8803 Rüschlikon(CH)

ACTORUM AG

## Description

The invention concerns an integrated circuit chip structure containing a plurality of integrated circuits and a plurality of wiring nets interconnecting said integrated circuit chips, at least one of said wiring nets being subjected to unduly high capacitive loading. In particular, the invention concerns an improvement by which it is possible to obviate, or at least reduce, the detrimental effects on electrical performance resulting from the unduly high capacitive load on these wiring nets.

The prior art has addressed the problem of highly capacitive wiring nets by employing push-pull outputs and/or higher power circuits. The push-pull circuit require more components and more silicon area on the chip.

The prior art includes numerous patents and publications directed to integrated circuit structure, wiring and circuitry for improving the operation of integrated circuitry contained on a semiconductor chip.

The following prior art patents and publications are directed to integrated circuit chip structure, circuitry and wiring.

### U.S. Patents

3 488 564 entitled "Planar Epitaxial Resistors".

3 513 365 entitled "Field-Effect Integrated Circuit and Method of Fabrication".

3,562,547 entitled "Protection Diode For Integrated Circuit".

3,534,236 entitled "Semiconductor Integrated Circuit Structure".

3,610,951 entitled "Dynamic Shift Register".

3,631,309 entitled "Integrated Circuit Bipolar Memory Cell".

3,656,004 entitled "Bipolar Capacitor Driver".

4,000,429 entitled "Semiconductor Circuit Device".

4,200,811 entitled "Frequency Divider Circuit".

4,249,193 entitled "LSI Semiconductor Device and Fabrication Thereof".

4,295,149 entitled "Master Image Chip Organization Technique or Method".

### Published EPO Patent Applications

European Patent Application 0114256 entitled "Improved TTL Circuit".

### Publications

"Use of Emitter in an Unused Transistor as an Underpass" by D.S. Hershman. IBM Technical Disclosure Bulletin, Vol. 14, No. 4, September 1971, page 1207.

"Integrated Delay Circuit" by H. Heimeier et al. IBM Technical Disclosure Bulletin, Vol. 21, No. 2, July 1978 pages 656–657.

"I.C.S. for Temperature Sensing and Control" by J.A. Morrison. Integrated Circuits, Vol. II, No. 20, October 17, 1978.

The present invention is directed to integrated circuit chips and is particularly useful for "gate arrays" or "master slices" where one or more circuits drive a highly capacitive on-chip wiring net. As is well known in the art, the driving of a highly capacitive on-chip wiring net is a burden which results in pulse delay and shrinkage. In accordance with the invention the chip structure is modified by compensation circuitry which can be coupled to the on-chip wiring net to mitigate the burden. It is possible to efficiently position on the chip a number of compensation circuits which are easily connected, as needed, during the fabrication on the chip. The employment of one, or a number of, on-chip compensation circuits does not materially increase the chip power consumption.

In VLSI, high capacitive loading of a wiring net must be addressed. As chips become larger and circuit density increases this problem intensifies. When an automatic wiring system wires the chip, it is frequently the situation that in the order of approximately 5% of the cases a high capacitive wiring net will occur. A high capacitive wiring net causes the internal circuit to have a significant increase in signal delay, or pulse transmission time. The disclosed technique will speed up these "problem" nets after the automatic wiring has been accomplished and without increasing the internal cell size.

The benefits of the invention may preferably be obtained by placing components of a "speed up" or compensation circuit in the silicon chip under a second level power bus. This integrated circuit chip location is particularly desirable in that frequently the silicon under the second level power bus is otherwise unused or blank. In general, a chip layout includes second level power busses which run the length of the chip. These power busses may be separated by a number, such as six to eight, of internal cells for power distribution.

Numerous "gate array" (or masterslice) layouts containing a sizeable number of wireable cells are known in the art. A large number of U.S. Patents and publications are directed to "gate array" (or masterslice) layouts, cells containing components, wiring interconnecting components contained in a cell, first level metal conductors and second level metal conductors. U.S. Patent No. 4 249 193 already identified supra is directed to an improved masterslice design technique including structure, wiring and method of fabricating very large scale integrated circuit devices.

It is the object of the invention to provide, in an integrated circuit chip structure comprising an array of integrated circuits and interconnecting wiring nets, means for eliminating or reducing the negative effects of a capacitive load which exists in operation for such wiring nets.

Figure 1A discloses a TTL circuit which may be employed in the practice of the invention. The TTL circuit of Fig. 1A is fully disclosed in European Patent Application 0 114 256 entitled "Improved TTL Circuit".

Figure 1B discloses a well known TTL circuit which may be employed in the practice of the invention.

Figure 1C discloses a DTL circuit which may be employed in the practice of the invention.

Figure 1D discloses a DTL circuit which may be employed in the practice of the invention.

Figure 2A discloses the TTL circuit of Figure 1A modified in accordance with the invention.

Figure 2B discloses the TTL circuit of Figure IB modified in accordance with the invention.

Figure 2C discloses the DTL circuit of Figure 1C modified in accordance with the invention.

Figure 2D discloses the DTL circuit of Figure 1D modified in accordance with the invention.

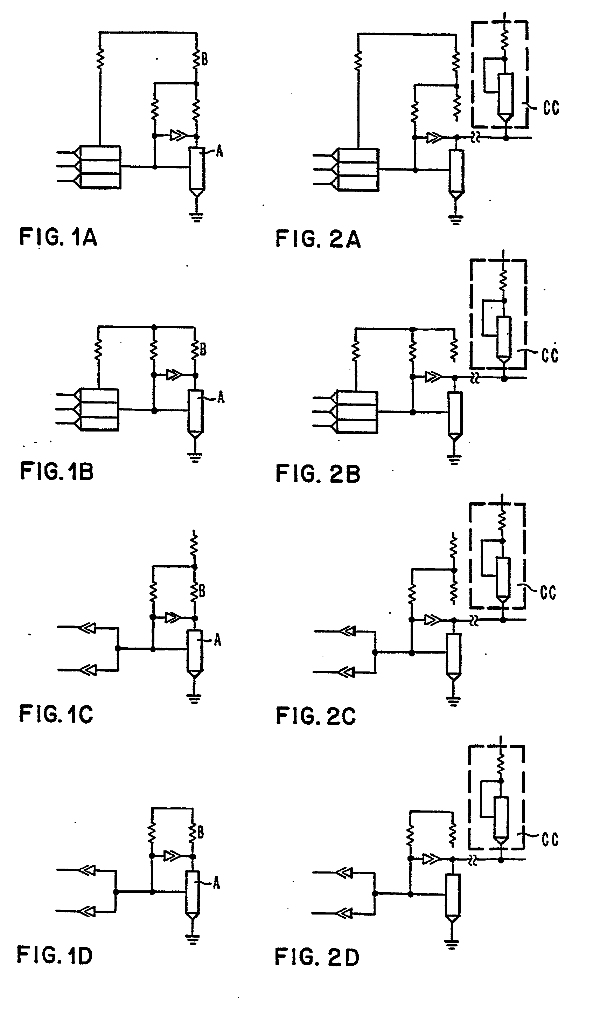

Figures 2A through 2D respectively further disclose a compensating (or speed-up) circuit employed in accordance with the practice of present invention.

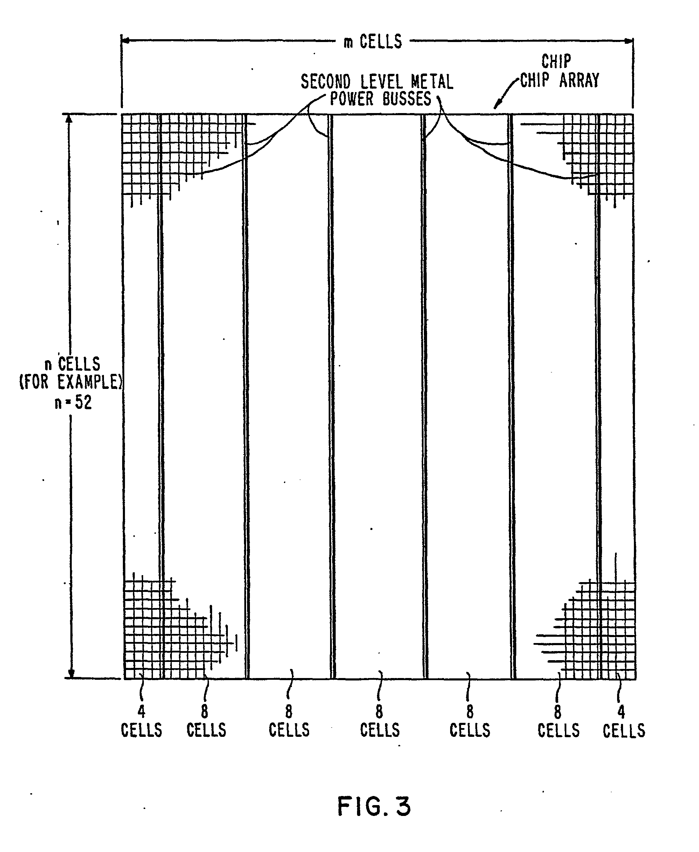

Figure 3 depicts an integrated circuit (masterslice, or gate array) chip having an array of cells of m columns and n rows whereby the chip has m x n cells. As further depicted in Figure 3, each row of cells has insulated therefrom and superimposed thereover a first level metal wiring channel. Each wiring channel comprises a plurality of first level metal conductors. Also represented in Figure 3 are a plurality of spaced apart second metal power busses. The second level metal power busses are superimposed over and insulated from the first level metal wiring channels.

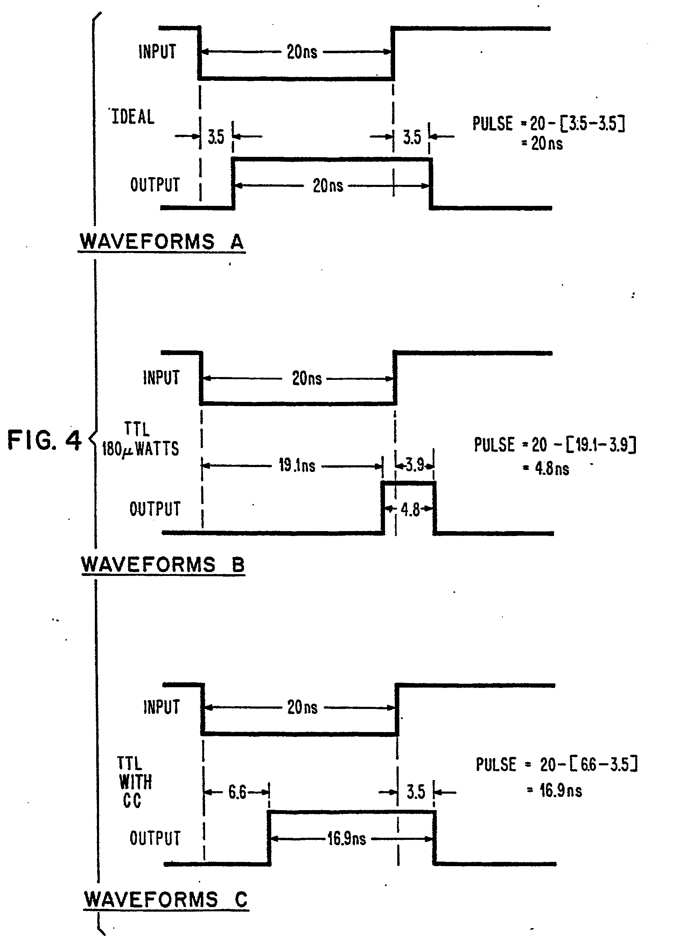

Figure 4 discloses illustrative waveforms A, B, C referred to hereinafter in the detailed explanation of the invention. Waveforms A depicts an ideal condition wherein an input pulse and an output pulse are of equal duration and the delay between the input and output pulse is relatively short. In waveforms B the pulse shrinkage (reduction in duration) and time delay between the input pulse and output pulse are very troublesome and pronounced if not totally unacceptable. Waveforms B illustrates the burden incurred, in the absence of the practice of applicants invention, where a relatively highly capacitive onchip wiring net must be driven. Waveforms C illustrates the benefits resulting from the practice of present invention, where a highly capacitive onchip wiring net must be driven. In waveforms C, it is seen that the "ideal" condition depicted by waveforms A is approached. Alternatively stated, the excessive delay and pulse shrinkage depicted by waveforms B is obviated or at least materially mitigated.

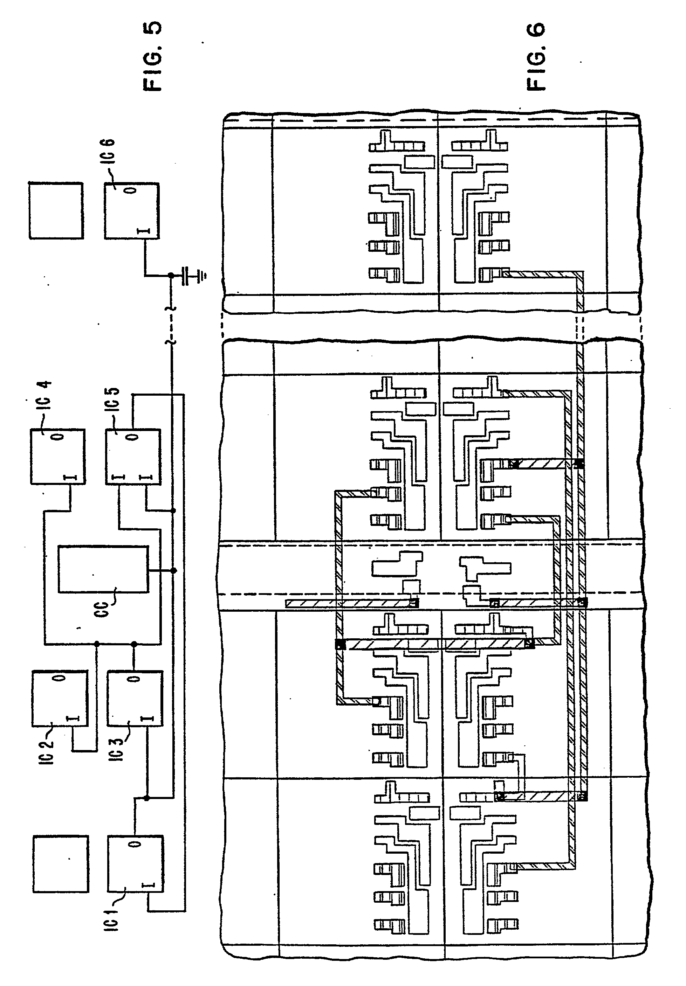

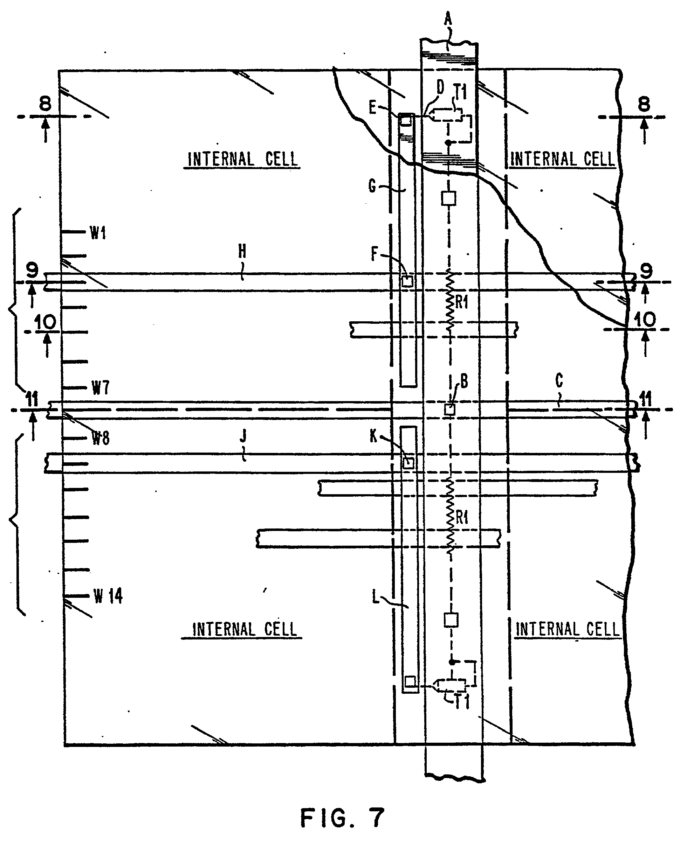

Figure 5 is a circuit schematic, in accordance with the invention, and corresponding to the structure and circuitry of Figure 6 concentrating on the particular net of interest.

Figure 6 is a planar view of a portion of an integrated circuit chip, such as depicted in Figure 3 and in accordance with the invention. Figures 5 and 6 illustrate an embodiment of the invention wherein the driving TTL circuit(s) and the driven TTL circuit are depicted as well as the interconnecting highly capacitive wiring net (first level metal) and a compensation circuit. Also illustrated is the placement of the compensation circuit beneath a second level metal power bus.

Figure 7 is a further view of a portion of an integrated circuit chip, such as depicted in Figure 2 and in accordance with the invention.

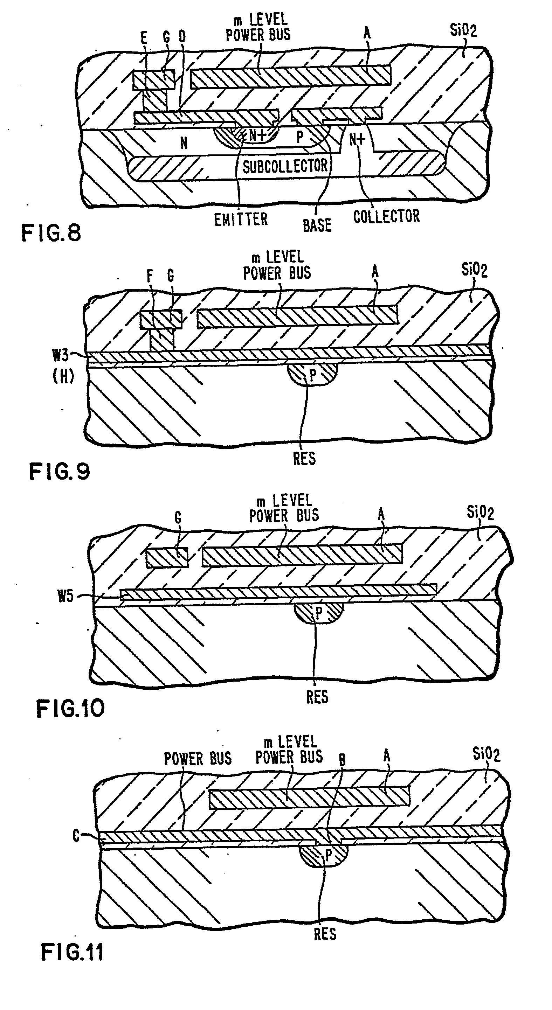

Figure 8 is a cross-sectional view taken along the lines 8-8 of Figure 7.

Figure 9 is a cross-sectional view taken along the lines 9-9 of Figure 7.

Figure 10 is a cross-sectional view taken along the lines 10-10 of Figure 7.

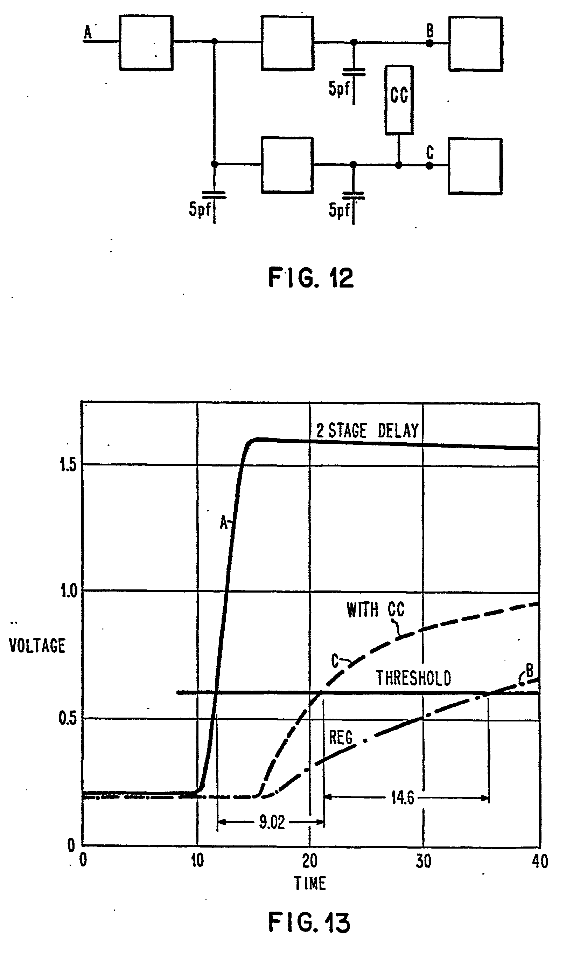

Figure 11 is a cross-sectional view taken along the lines 11-11 of Figure 7.

Figure 12 is a circuit block diagram referred to in the explanation of the waveforms of Figure 13.

Figure 13 discloses waveforms illustrative of the operation of the invention, as contrasted to waveforms of the prior art. In the explanation of the waveforms set-forth hereinafter reference is made to the circuit block diagram of Figure 12.

Detailed Description of the Invention and Preferred Embodiment:

As chips become larger and the interconnections between gates become more complex, the occurrence of high capacitive wiring nets increases. The TTL circuit family has a weakness at high capacitive loading which is intensified as circuit power is lowered. The problem is seen in the rising transition of the output. The delay (when heavily loaded) is greatly determined by an RC time constant. The circuitry in accordance with the invention will provide a much lower RC time constant for the high capacitive nets. This "limited" use of circuit modification including a speed-up circuit solves the loading problem while adding minimal power to the overall chip requirement. For example, a TTL circuit operating with a power of 180 micro watts may have a 19 nano second $T_{off}$ (rising output) delay. This compares with a 6.6 nano second delay for the circuit as modified in accordance with the invention. Figure 1A is in accordance with the prior art. Figure 2A is in accordance with the invention.

Another critical aspect of circuit performance is pulse shrinkage. The ideal case is when both edges ($T_{on}$, $T_{off}$) have the same delay. The waveforms of Figure 4 illustrate pulse delay and pulse shrinkage for ideal circuitry, for circuitry in accordance with the prior art, and for circuitry in accordance with the invention. Waveforms A show the ideal case where a 20 ns input pulse yields of 20 ns output pulse. Waveforms B show the case of a TTL circuit loaded with a highly capacitive output wiring net. Since the delay of the leading edge is much longer than the trailing edge, very significant pulse shrinkage occurs. In the illustrative example, a 20 ns input pulse is transformed into a 4.8 ns output pulse. Waveforms C show the case of a TTL circuit loaded with a highly capacitive output net and modified in accordance with the invention. From waveforms C it is seen that an input pulse of 20 nanoseconds results in an output pulse of 16.9 nanoseconds. It is apparent that the circuitry in accordance with the invention is very effective in minimizing the skew between the input and output pulses.

To be an effective solution the circuitry added and modified in accordance with the practice of the invention must be easily implemented and have minimal impact on chip size. The additional circuitry does not make a demand on chip silicon space since the circuit components thereof may be placed in chip silicon under a second metal power bus. (In many, if not most, gate array chips the silicon area under a second level metal bus is not utilized for cells or in any manner.) When the automatic wiring system generates a highly capacitive wiring net, for example 5pf, the additional circuitry may be implemented by omitting a contact and placing a via; no rewiring is necessary. As will be fully apparent from the further description hereinafter (with detailed reference to the drawings) to generate a large capacitance a considerable amount of first level metal is required. For a brief overall understanding of the invention at this point the explanation will be limited to Figure 7. Fig. 7 shows four internal cells (two by two) separated by a vertically extending second level metal power bus. There are two speed-up, or compensation, circuits shown in the drawing. Figure 7 also illustrates the physical placement and components (T1, R1) of each of the speed circuits.

The components of the speed-up circuits (T1 & R1) are located under the second metal level power bus (A), which minimizes the space required to use the compensation circuit. The resistor end of each compensation circuit is connected (B) to the power supply on a first metal level conductor (C). The emitter end of the circuit (D) is connected (E) to a second metal level wiring tab (G) which runs parallel to the second metal level power bus (A) crossing over all wiring channels (Wn) in that row of internal cells. The circuit is connected by placing a via (F) between the second metal level wiring tab (G) and a high capacitive first metal level conductor line (H) crossing under it. Figure 7 shows two rows of internal cells and their corresponding speed-up circuits. Figure 7 discloses a small portion of Figure 3. Figure 3 illustrates second level metal power bussing on a gate array (or masterslice) chip. Figure 3, for purposes of illustration, shows an internal matrix of 48X52 cells with six second level metal vertical power busses. This would allow 312 (6X52) speed-up circuits.

With the tendency to increase chip size and lower circuit power the problem of high capacitive nets has become a major concern. The practice of the disclosed invention provides an effective solution (with minimal impact on the automatic wiring system, chip size, and chip power) to the problem and burden of driving highly capacitive on-chip wiring nets.

Figures 1A-1D show various types (TTL and DTL) of logic circuits. These circuits have a problem as circuit power is reduced because the falling and rising output transitions have different sensitivities to capacitive loading. During the falling transition the output transistor (A) is turned on yielding a low impedance path to ground. During the rising transition the RC time constant of the collector resistor (B) determines the speed. This RC time constant is increased more and more as the need for lower power circuits arise. Because of this transition speed "skew" problem, a major concern is pulse shrinkage. Figure 4 illustrates this problem by means of some timing diagrams. Waveforms A represent the ideal case where the rising and falling delay are equal. If this were true the pulse output would always equal the input pulse. Waveforms B illustrate what happens with a real circuit loaded with 5 picofarads. The rising output delay is 19.1 ns while the falling output delay is 3.9 ns yielding a pulse shrinkage of 15.2 ns. The compensating circuit reduces the effect of the load capacitance on the rising output in order to alleviate this "skew" problem. Figures 2A through 2D respectively show a compensating circuit CC used in conjunction with the circuits shown in Fig. 1A through 1D. The compensating circuit components offer the rising transition a much lower impedance path to the power supply.

The improvement in capacitive sensitivity can be seen in Figures 12 and 13. Figure 12 shows how the waveforms were generated across 2 stages each being loaded to 5 picofarads. Waveform A in Fig. 13 represents the input, and waveforms B and C represent the TTL output and the compensated TTL circuit output, respectively. This illustration clearly shows that the effect of the large capacitance has been significantly reduced with the compensating circuit. Fig. 4 waveform C shows how the delay improvement has alleviated the pulse shrinkage problem. Although the rising output delay (6.6ns) is still slower than the falling output delay (3.5ns) the pulse shrinkage has been reduced to 3.1 ns as opposed to the previous 15.2 ns. This significant improvement is primarily achieved because the compensating circuit speeds up the slower transition (rising output) a great deal and effects the other transition minimally.

Fig. 3 depicts a generalized chip structure which contains 52 vertical and 48 horizontal cells. For power distribution power busses are placed at some fixed increment which is 8 cells for this example. There is one compensating circuit for each power bus in each cell height. This results in 52X6 compensating circuits. It can be clearly seen that any wire having a large capacitance would have a high probability of passing under one of the power busses shown in Fig. 3.

Fig. 7 shows where a compensating circuit is placed and how it is connected. The components are placed under the second level metal power bus (A). A piece of first level metal (D) is used to connect the emitter to a via, i.e. a first level metal to second level metal connection (E). A piece of second level metal (G) makes a connection to the via (E) and crosses over all the first level metal wiring channels (W1-W7). If one of the first level wiring channels has a large capacitive net, a via F can be placed connecting the compensating circuit to the desired line. Figures 8-11 are cross sectional views, respectively taken along the lines 8-8, 9-9, 10-10, and 11-11 of Figure 7 to clarify the illustration.

Fig. 5 is an example of TTL logic circuit connections (no particular function) and how a compensating circuit is employed. The driving circuits are designated as IC1...IC5, the driven circuit is designated as IC6, and the compensation circuit is designated as CC. In conjunction with the logic diagram of Figure 5 a chip layout is shown in Figure 6. Solid black squares depict first to second level connections (vias). This illustration, Figure 6, shows the interconnection of a compensating circuit in an actual chip layout.

To summarize the foregoing, the problem to be solved is to quickly remove the charge from highly capacitive wiring nets to reduce pulse delay and pulse shrinking. To solve this problem, a plurality of unconnected compensation circuits are provided at various locations throughout the chip. When a high capacitance wiring net occurs, then a selected compensation circuit adjacent to that wiring net may be connected to remove the charge in that net quickly. This solution effectively removes the delay and pulse shrinkage problem for capacitive nets, without the necessity of rewiring or using a compensation circuit in every one of the integrated circuits IC1 to IC5.

In an embodiment of the present invention, the integrated circuit chip includes: a plurality of integrated circuits formed in the semiconductor chip; a plurality of first level metal conductors (W1 ... W14) for interconnecting at least certain of the plurality of integrated circuits to a plurality of circuit wiring nets; at least one of the plurality of circuit wiring nets possessing an undesirable electrical characteristic; and a plurality of additional metal conductors (A, G, L) superimposed over the first level metal conductors, for selectively interconnecting them, or for providing power to the circuitry.

In particular, this semiconductor chip contains at least one additional circuit (CC; R1, T1) which is formed in said semiconductor chip and which is interconnected via one of the second level metal conductors (G) and one of the first level metal conductors (W3, H) with the circuit wiring net possessing the undesirable electrical characteristic; the additional circuit possessing an electrical characteristic which substantially compensates for said undesirable electrical characteristic of said wiring net.

In a preferred embodiment, the additional circuit (CC) consists of unilaterally conductive two terminal circuit means (R1, T1).

In a particular embodiment of the present invention, the integrated circuit chip comprises: a plurality of integrated circuits (IC1–IC5) formed in said semiconductor chip; a first plurality of spaced apart insulated conductor nets (H, J) substantially at a first level above the semiconductor chip for interconnecting a plurality of the integrated circuits (IC1–IC5); a power supply; and a plurality of unconnected compensation means (R1, T1) formed in the semiconductor chip, each of the compensation means connected to a power supply line (C), each of the compensation means being disposed in the chip adjacent to selected different ones of the conductor nets, the compensation means for providing a low impedance path, when connected, between the power supply and the selected conductor net to which it is connected, to thereby mitigate the detrimental effect of unduly large capacitance on said selected conductor net.

In a preferred embodiment of the present invention, the compensation means in the integrated circuit chip are formed in rows in the semiconductor area of said semiconductor chip directly below selected ones (A) of spaced apart second level conductors.

Fig. 8 is a cross-sectional view of Fig. 7 taken along the lines 8–8 showing the second level metal line (G) making contact through the via E and the first level metal line D with the emitter (N+) of the transistor T1. It is clear from the figure that transistor T1 is disposed below the second level metal power bus A.

Fig. 9 is a cross-sectional view of Fig. 7 taken along the lines 9–9. Fig. 9 shows the diffusion for the resistor R1 (RES) disposed below the second level metal power bus (A) and further shows the second level metal line (G) making contact to the first level metal line (W3) by means of the via (F).

Fig. 10 is a cross-sectional view taken along the lines 10–10 of Fig. 7. Fig. 10 again shows the diffusion for the resistor R1 (RES) disposed below the second level metal power bus (A). The figure clarifies that the second level metal line (G) and the first level metal line (W5) are not connected.

Fig. 11 is a cross-sectional view taken along the lines 11–11. Fig. 11 shows the second level metal power bus (A), the diffusion for the resistor R1 (RES) and the connection of the resistor R1 to the first level metal line (C) by means of the via (B).

**Claims**

1. An integrated circuit chip, comprising:
a plurality of integrated circuits (IC1 ... IC5) formed in a semiconductor chip;
a plurality of spaced apart insulated conductor nets (W1 ... W14; H, J) substantially at a first level above said semiconductor chip for interconnecting at least some of said integrated circuits; and
a power supply line (C) connected to a power supply; characterized by
a plurality of compensation circuits (CC; T1, R1) formed in said semiconductor chip;
– each of said compensation circuits disposed in said chip adjacent to different ones of said conductor nets (H, J),
– each of said compensation circuits connected to said power supply line (C),
– any of said compensation circuits when connected (D, E, F, G) to a conductor net (H), providing a low impedance path between the power supply and that conductor net, to thereby mitigate the detriment effect of unduly large capacitance on the respective conductor net.

2. An integrated circuit chip according to claim 1, further comprising a plurality of spaced apart insulated conductors (A, G, L) at a second level above said semiconductor chip and extending in substantially one direction, at least some of said second level conductors (A) being power supply lines; characterized in that said compensation circuits (CC; T1, R1) are formed in rows in the semiconductor area of said semiconductor chip directly below selected ones (A) of said spaced apart second level conductors.

3. An integrated circuit chip according to claim 1, wherein said plurality of integrated circuits (IC1 ... IC5) are of the TTL or DTL family.

4. An integrated circuit chip according to claim 1, wherein each of said compensation circuits (CC; T1, R1) consists of resistance means (R1) and a diode (T1) connected in series.

5. An integrated circuit chip according to claim 4, wherein said diode in each of said compensation circuits is constituted by a diode-connected transistor (T1).

6. An integrated circuit chip according to claim 1, further comprising means (D, E, F, G) for connecting at least one of said conductor nets (H) to an adjacent compensation circuit (T1, R1).

## Patentansprüche

1. Integrierter Schaltungs-Chip mit:
einer Mehrzahl von integrierten Schaltungen (IC1...IC5), die in einem Halbleiter-Chip gebildet sind;
einer Mehrzahl von separaten, isolierten Leiternetzen (W1...W14; H, J), die im wesentlichen auf einer ersten Ebene über dem Halbleiter-Chip angeordnet sind, um mindestens einige der integrierten Schaltungen untereinander zu verbinden;
einer Stromversorgungsleitung (C), die mit einer Stromversorgung verbunden ist; gekennzeichnet durch
eine Mehrzahl von Kompensationsschaltungen (CC; T1, R1), die in dem Halbleiter-Chip gebildet sind, wobei
– jede der Kompensationsschaltungen in dem Chip in Nachbarschaft zu verschiedenen der Leiternetze (H, J) angeordnet ist,
– jede der Kompensationsschaltungen mit der Stromversorgungsleitung (C) verbunden ist,
– jede beliebige der Kompensationsschaltungen, wenn sie mit einem Leiternetz (H) verbunden (D, E, F, G) ist, einen Pfad niedriger Impedanz zwischen der Stromversorgung und dem betreffenden Leiternetz ergibt, um dadurch die nachteilige Wirkung einer übermäßig großen Kapazität auf das betreffende Leiternetz zu vermindern.

2. Integrierter Schaltungs-Chip gemäß Anspruch 1, welcher zusätzlich enthält: eine Mehrzahl von separaten, isolierten Leitern (A, G, L), die auf einer zweiten Ebene über dem Halbleiter-Chip angeordnet sind und sich im wesentlichen in einer Richtung erstrecken, wobei mindestens einige dieser Leiter (A) der zweiten Ebene Stromversorgungsleitungen sind; dadurch gekennzeichnet, daß die Kompensationsschaltungen (CC; T1, R1) in Reihen geformt sind, und zwar im Halbleiterbereich des Halbleiter-Chips, welcher direkt unter ausgewählten Leitern (A) der separaten Leiter der zweiten Ebene liegt.

3. Integrierter Schaltungs-Chip gemäß Anspruch 1, worin die Mehrzahl von integrierten Schaltungen (IC1...IC5) zur TTL- oder DTL-Familie gehört.

4. Integrierter Schaltungs-Chip gemäß Anspruch 1, worin jede der Kompensationsschaltungen (CC; T1, R1) aus einem Widerstand (R1) und einer damit in Reihe geschalteten Diode (T1) besteht.

5. Integrierter Schaltungs-Chip gemäß Anspruch 4, worin die Diode in jeder der Kompensationsschaltungen durch einen als Diode geschalteten Transistor (T1) gebildet wird.

6. Integrierter Schaltungs-Chip gemäß Anspruch 1, welcher zusätzlich enthält: Mittel (D, E, F, G), um mindestens eines der Leiternetze (H) mit einer benachbarten Kompensationsschaltung (T1, R1) zu verbinden.

## Revendications

1. Puce de circuits intégrés comprenant:
une pluralité de circuits intégrés (IC1...IC5) formés dans une puce semiconductrice;
une pluralité de réseaux conducteurs isolés les uns des autres (W1...W14; H, J) sensiblement à un premier niveau sur la puce semiconductrice pour interconnecter au moins certains des circuits intégrés; et
une ligne d'alimentation (C) connectée à un dispositif d'alimentation, caractérisée par
une pluralité de circuits de compensation (CC; T1, R1) formés dans la puce semiconductrice:
– chacun des circuits de compensation étant disposé dans la puce de façon adjacente à certains différents des réseaux conducteurs (H, J),
– chacun des circuits de compensation étant connecté à la ligne d'alimentation (C),
– n'importe lequel des circuits de compensation, lorsqu'il est connecté (D, E, F, G) à un réseau conducteur (H), fournissant un trajet de faible impédance entre le dispositif d'alimentation et ce réseau conducteur, pour diminuer ainsi l'effet nuisible d'une capacité trop importante sur le réseau conducteur respectif.

2. Puce de circuits intégrés selon la revendication 1, comprenant en outre une pluralité de conducteurs isolés séparés dans l'espace (A, G, L) à un deuxième niveau sur la puce semiconductrice et s'étendant selon sensiblement une direction, au moins certains des conducteurs de deuxième niveau (A) étant des lignes d'alimentation, caractérisée en ce que les circuits de compensation (CC, T1, R1) sont formés selon des rangées dans la région semiconductrice de la puce semiconductrice directement au-dessous de ceux sélectionnés (A) des conducteurs de deuxième niveau séparés dans l'espace.

3. Puce de circuits intégrés selon la revendication 1, dans laquelle les circuits intégrés (IC1...IC5) appartiennent aux familles TTL ou DTL.

4. Puce de circuits intégrés selon la revendication 1, dans laquelle chacun des circuits de compensation (CC; T1, R1) consiste en des moyens de résistance (R1) et en une diode (T1) connectés en série.

5. Puce de circuits intégrés selon la revendication 4, dans laquelle la diode dans chacun des circuits de compensation est constituée par un transistor connecté en diode (T1).

6. Puce de circuits intégrés selon la revendication 1, comprenant en outre des moyens (D, E, F, G) pour connecter au moins l'un des réseaux conducteurs (H) à un circuit de compensation adjacent (T1, R1).

EP 0 186 769 B1

FIG. 1A

FIG. 2A

FIG. 1B

FIG. 2B

FIG. 1C

FIG. 2C

FIG. 1D

FIG. 2D

FIG. 3

EP 0 186 769 B1

FIG. 4

WAVEFORMS A

PULSE = 20 − [3.5 − 3.5]
= 20 ns

WAVEFORMS B

TTL
180 μ WATTS

PULSE = 20 − [19.1 − 3.9]
= 4.8 ns

WAVEFORMS C

TTL
WITH
CC

PULSE = 20 − [6.6 − 3.5]
= 16.9 ns

FIG. 5

FIG. 6

FIG. 7

FIG.8

FIG.9

FIG.10

FIG.11

FIG. 12

FIG. 13